# EUROPEAN PATENT APPLICATION

(11) **EP 1 724 809 A1**
(43) Date of publication of application: **22.11.2006**
(21) Application number: 05076151.9
(22) Date of filing: 18.05.2005
(51) Int. Cl.: H01J 37/28

(54) **Particle-optical apparatus for the irradiation of a sample**

(71) Applicant: FEI COMPANY, Hillsboro, Oregon 97124-5793 (US)
(72) Inventor: Knowles, Ralph W., Newbury MA-01951 (US)
(74) Representative: Bakker, Hendrik

(57) **Abstract**

Many particle-optical apparatus operate with a gas pressure near the sample (118) higher than in the particle-optical column. To avoid leakage into the column a pressure limiting aperture (PLA) with a small diameter is used through which the particle beam (160) leaves the column. Often there is also the need to combine the use of such a column with a path for electro-magnetic radiation, e.g. for the detection of X-rays or when a light-optical microscope is included for observation and/or navigation. Creating a path for this radiation (and optical elements thereof) typically results in an increased working distance for the column, resulting in several disadvantages. The invention offers a solution by placing a window (156) transparent to the electro-magnetic radiation but impervious to gas adjacent to the PLA (140), through which the beam of radiation (170) can enter and/or emerge from the column, to be guided and/or detected further.

## Description

The invention relates to a particle-optical apparatus for the irradiation of a sample, comprising
- a source for the production of a particle beam,
- an evacuated enclosure enclosing said source, and
- an aperture in said enclosure,
- in which
- the particle beam emerges from the enclosure through the aperture and subsequently travels to a sample,
- a gas pressure gradient exists through the aperture, and
- electromagnetic radiation emerges from or impinges on the sample.

Such an apparatus is known from the US patent document No. 5,362,964.

Such apparatus are used nowadays for e.g. the inspection and/or modification of samples.

An example of such an apparatus is a LVSEM (Low Vacuum Scanning Electron Microscope). Such an apparatus contains a source for the production of a particle beam, i.e. a beam of electrons. This particle beam is manipulated by particle-optical elements, such as particle-optical lenses and deflectors. The source and the particle-optical elements are located in an enclosure, the so-called particle-optical column. Due to demands of the particle source and the particle-optical elements, the inside of the column is evacuated to a low pressure of e.g. less than 10⁻³ mbar. The particle beam leaves the column through an aperture and is positioned on or scanned over a sample.

Where the particle beam impinges on the sample it induces secondary particles, which secondary particles can be detected by suitable detectors. Position-dependent information is thus acquired from the sample, enabling inspection of the sample.

The LVSEM is arranged to admit e.g. water vapour to the vicinity of the sample at a pressure of e.g. 20 mbar. The ability to admit water vapour enables the inspection of e.g. biological samples at a temperature of approximately 10 °C without de-hydrating them, as e.g. 12 mbar is the equilibrium pressure of liquid water at a temperature of approximately 10 °C.

Another example of such an apparatus is a FIB (Focused Ion Beam) apparatus. In a FIB the particle beam constitutes a beam of ions. Instead of admitting water vapour to the vicinity of the sample, a FIB is often arranged to admit other vapours or gasses to the vicinity of the sample. Depending on the gas admitted and the composition of the sample, the ion beam impinging on the sample may induce etching of the sample, or it may induce deposition of material onto the sample, said material being present in the gas phase in the vicinity of the sample. Said etching and deposition enable modification of the sample.

In both a LVSEM and a FIB the admittance of gasses or vapours results in a gas pressure at the sample side of the enclosure that is higher than the pressure maintained in the enclosure. The resulting pressure gradient through the aperture causes gas leakage from the sample side of the enclosure to the inside of the enclosure. To limit the gas leakage the diameter of the aperture is generally limited to e.g. 300 µm. This relatively small diameter limits the area over which the particle beam can be scanned.

For several reasons there is a demand to combine the use of a particle-optical column of the mentioned types with the use of electromagnetic radiation. Some examples are:
- When using an apparatus such as a LVSEM or a FIB, where the sample is irradiated by particles emerging from the enclosure through a small aperture, coarse navigation and positioning of the sample to be inspected can be performed with an optical or infrared microscope, detecting visible or infrared light.
- Etching and deposition caused by charged particles in e.g. a FIB can be enhanced by simultaneously irradiating the sample with light.
- The irradiation with charged particles in e.g. a LVSEM induces electromagnetic radiation in the form of e.g. X-rays, detection thereof offering additional information about the sample.

In said US patent document No. 5,362,964 a LVSEM is described with an optical system. The optical system comprises a mirror mounted between enclosure and sample, a light source, a CCD imaging detector, and may comprise several prisms and lenses.

Because part of the optical system and its associated light path is placed between the aperture and the sample, the position where the sample may be located is obstructed. Also, the position of detectors may be obstructed. To overcome this problem the distance between aperture and sample (the working distance) must increase when compared to the situation where no optical system is used.

A disadvantage of the increased working distance is that it decreases the performance of the particle-optical column. As known to a person skilled in the art of particle optics the highest resolution of a particle-optical apparatus is obtained at minimal distance between the sample and the particle-optical lens focusing the particle beam onto the sample, because a small distance from lens to sample implies a high strength of the lens and thus smaller lens aberrations. The highest resolution is thus obtained when the working distance is minimized.

Another disadvantage of the increased working distance is that it makes the use of immersion lenses for the focusing of the particle beam impossible. An immersion lens is a lens in which the sample is placed in the focusing field (magnetic or electrostatic) of the lens. Immersion lenses offer superior aberrations when compared to non-immersion lenses, resulting in higher resolution of the particle-optical apparatus. As known to one skilled in the art the use of an immersion lens implies a small working distance.

Yet another disadvantage caused by the longer working distance is that the efficiency of through-the-lens detection of secondary particles, such as secondary electron, decreases. Through-the-lens detection of secondary particles is desirable when e.g. a detector is used that has to operate at a higher vacuum than available in the vicinity of the sample. This decrease of efficiency is a result of the decrease of the opening angle at which the aperture (through which the secondary particles have to enter the enclosure) is seen from the sample (where the secondary electrons originate). Efficiency of through-the-lens detection is also decreased because, at a longer working distance, the secondary particles have a larger probability of interacting with the gasses and vapours before entering the enclosure, where a lower pressure exists. Depending on gas pressure and composition, such interaction may lower the efficiency.

Another disadvantage of said optical system is that its elements and its associated optical path interfere with the volume in which the sample can be moved. A large volume is desirable, especially when observing large samples or when a large degree of freedom is required.

Yet another disadvantage of said optical system is that the optical lenses are placed far from the sample. This results in a limitation of the optical resolution. It also limits the numerical aperture of the optical system.

It is an object of the invention to provide a particle-optical apparatus arranged to operate with a working distance that is smaller than attainable with the apparatus according to the known patent document.

To that end, the apparatus according to the invention is characterized in that
- the enclosure comprises a window adjacent to the aperture,
- said window being transparent to electromagnetic radiation and impenetrable to gas.

The invention is based on the insight that, by introducing a window transparent to electromagnetic radiation close to the aperture, it is possible to create a path for said radiation while minimizing the working distance. Any necessary optical elements may be included in the enclosure, between source and aperture. By using a material impenetrable to gas, the window does not introduce increased gas leakage.

As a result of the smaller working distance the apparatus according to the invention overcomes the afore mentioned disadvantages of the apparatus according to the known patent document.

It is to be remarked that the apparatus according to the invention can also be used in applications where the vacuum in the vicinity of the sample is better than the vacuum on the inside of the enclosure. Such an application is e.g. Auger microscopy, where the sample is preferably kept at a pressure of e.g. 10⁻⁹ mbar or better.

An additional advantage of a smaller working distance is that the pressure gradient that exists through the aperture can be located close to the sample. This minimizes the volume where the particle beam interacts with the gas. As a consequence scattering of particles, resulting from said beam interaction, is minimized as well, resulting in improved particle-optical performance. This makes the apparatus according to the invention fit for use with pressures in excess of e.g. 20 mbar and/or with low beam energies (e.g. less than 1 keV), for which the effect of scattering is more pronounced.

In an embodiment of the apparatus according to the invention the apparatus is arranged to maintain a pressure gradient through the aperture of at least one order of magnitude.
In LVSEM and FIB apparatus pressure gradients in excess of one order of magnitude are often used.

In a further embodiment of the apparatus according to the invention the apparatus is arranged to admit gasses to the vicinity of the sample.

In another embodiment of the apparatus according to the invention the window acts as a refractive element.
By using a window in the form of e.g. a lens it is possible to locate the objective lens of the optical system close to the sample. This improves the optical performance of such a system.

In still another embodiment of the apparatus according to the invention the window passes a beam of electromagnetic radiation, said beam and the particle beam being mutually coaxial.
An advantage of having two coaxial beams is that, when the working distance is changed, the two beams always target the same area on the sample.

In yet another embodiment of the apparatus according to the invention the electromagnetic radiation is visible light.

In still another embodiment of the apparatus according to the invention the electromagnetic radiation is X-ray radiation.

In another embodiment of the apparatus according to the invention the window is located in a pole piece of a particle-optical lens.

The invention will be elucidated on the basis of figures, where identical reference numerals indicate corresponding elements.
To this end:
- Figure 1 schematically depicts the particle-optical apparatus according to the invention, in which the particle beam irradiates the sample and a detector detects electromagnetic radiation emanating from the sample.
- Figure 1A shows detail of area I of figure 1, showing the sample end of the enclosure, in which the particle beam passes through the aperture and electromagnetic radiation through the window.
- Figure 2 schematically shows an embodiment of the particle-optical apparatus according to the invention, in which the particle beam and a beam of electro-magnetic radiation are mutually coaxial.
- Figure 2A shows detail of area II of figure 2, showing the two coaxial beams.
- Figure 2B shows detail of area II of figure 2, in which the window is shaped as an optical element.
- Figure 2C shows detail of area II in figure 2, in which an electrically conductive tube surrounds the particle beam.
- Figure 2D shows detail of area II in figure 2, in which the window is shaped as an off-axis part of a lens.
- Figure 3 schematically illustrates the apparatus according to the invention, showing a LVSEM with a particle-optical lens of the immersion type.
- Figure 3A shows detail of area III of figure 3, showing the secondary electrons being guided through the aperture to the inside of the enclosure.

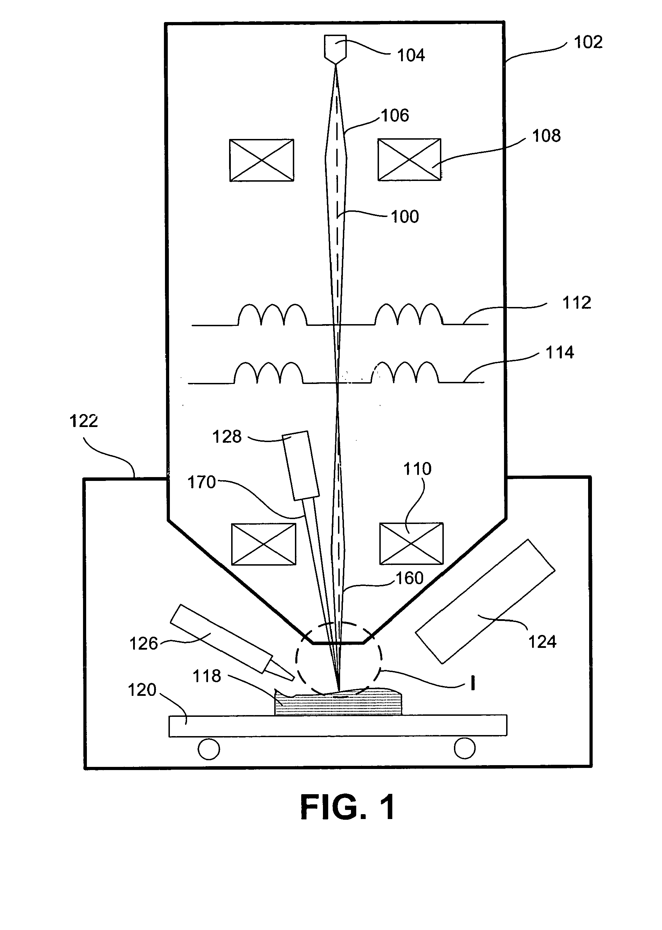

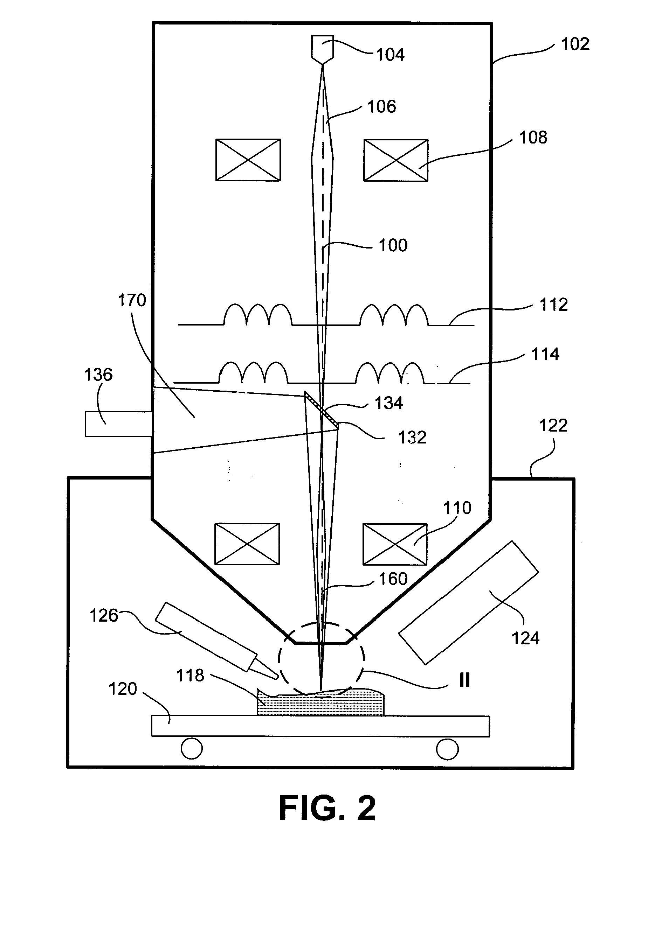

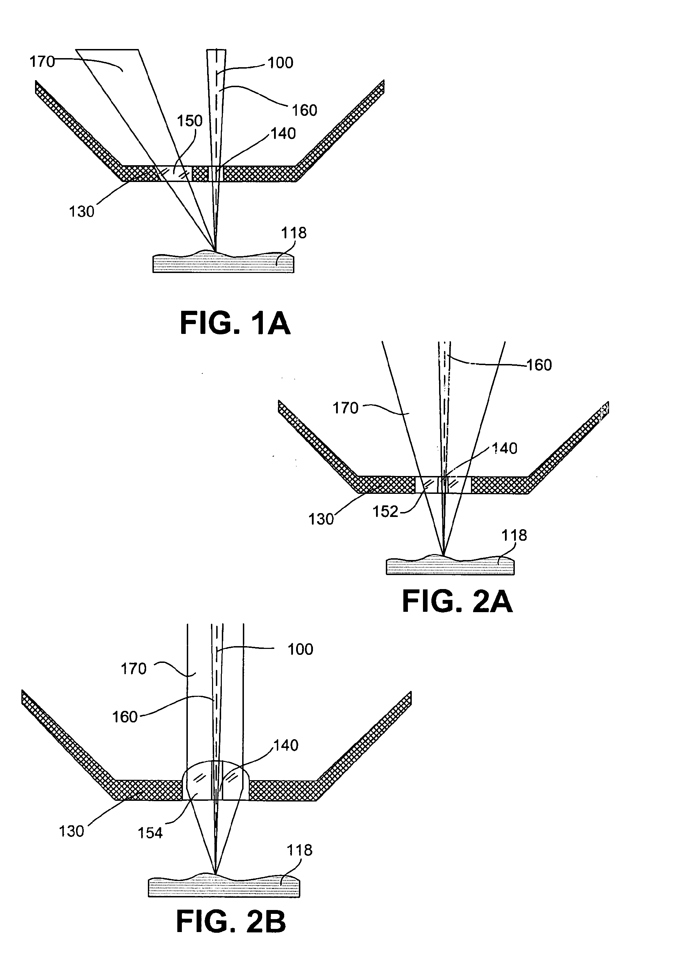

Figure 1 schematically depicts the particle-optical apparatus according to the invention, in which the particle beam irradiates the sample and a detector detects electromagnetic radiation emanating from the sample.

The enclosure 102 contains the particle source 104 producing a particle beam 106, such as a beam of electrons or ions, along a particle-optical axis 100. Particle-optical lenses 108, 110 and particle-optical deflectors 112, 114 manipulate this particle beam 106. As a result the focused particle beam 160 leaves the enclosure102 through an aperture 140 (shown in figure 1A). The particle beam 160 irradiates the sample 118 in a scanning fashion. The sample 118 is located on a movable sample holder 120, with which the sample is positioned such that the particle beam 160 may scan an area of interest on the sample. A detector 124 detects secondary electrons emanating from the sample. A gas source 126 admits gas, such as water vapour, to the vicinity of the sample. Sample 118, sample holder 120, detector 124 and gas source 126 are enclosed in a vacuum chamber 122. The inside of enclosure 102 is kept at a vacuum of e.g. 10⁻³ mbar and the inside of vacuum chamber 122 is kept at a vacuum of e.g. 10 mbar by vacuum pumps (not shown).

Figure 1A shows detail of area I of figure 1, showing the sample end 130 of the enclosure 102, in which the particle beam 160 passes through aperture 140 and in which electromagnetic radiation 170, emanating from the sample 118, passes through a window 150. The window 150 is adjacent to aperture 140, so that radiation emanating from the area of interest (as defined by the scanning of particle beam 160) can pass through it.

Returning to figure 1, the electromagnetic radiation 170 coming from the sample 118 passes through the window 150 and is detected by a detector 128 placed inside the enclosure 102.

It is remarked that detector 128 may be a detector sensitive to light, but it may also be a detector sensitive to X-ray radiation for the detection of X-rays emanating from the sample.

It may be remarked that the kind of radiation to be passed by the window determines what materials may be used in that window (provided the materials are impenetrable to gas). For visible light e.g. glass can be used, for infrared e.g. germanium and for X-rays a beryllium window can be used.

It may further be remarked that e.g. glass is a material that easily charges when irradiated by charged particles. To avoid such charging, the material of the window 150 can be coated with a transparent layer of electrically conductive material, e.g. ITO (Indium Tin Oxide).

It is also remarked that the side of the aperture located at the inside of the enclosure may be at a vacuum compatible with the demands of e.g. the particle source, but that this is not essential to the apparatus according to the invention. It is also possible to have a further pressure reduction from the aperture towards the source by e.g. passing the beam through one or several gas constrictions.

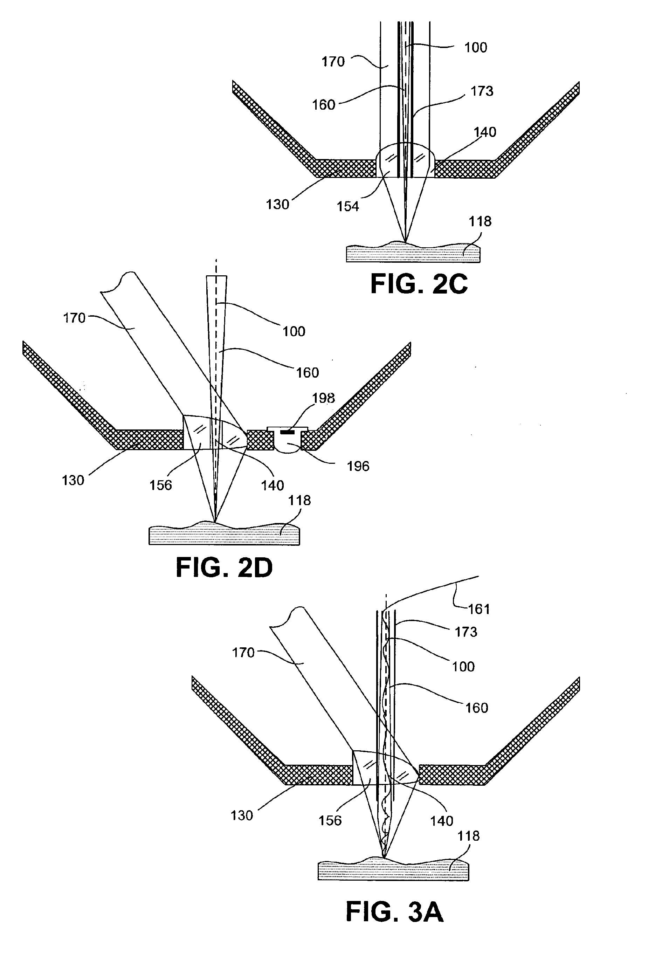

Figure 2 schematically shows an embodiment of the particle-optical apparatus according to the invention, in which the particle beam and the beam of electromagnetic radiation in the form of a beam of light are mutually coaxial.
Figure 2 can be thought to be derived from figure 1. A mirror 132 placed in the enclosure 102 has a hole 134 to pass the particle beam, while deflecting the beam of light 170 away from the particle-optical axis 100. The beam of light 170 then exits the enclosure 102 through a window in the side wall of the enclosure 102, where a detector such as a camera 136 placed outside the enclosure detects said beam 170.

Figure 2A shows detail of area II depicted in figure 2. The window 152 is made of a material transparent to the light emanating from the sample.

The window 152 has a central hole, said central hole being the aperture 140 and passing the particle beam 160.

It is remarked that it is not essential to the invention that the window 152 completely encircle the aperture 140, nor that the hole be a central hole.

It is also remarked that, although the embodiment shows a beam of radiation 170 coming from the sample 118, in this and other embodiments likewise a beam of radiation in the form of e.g. infrared, light or UV can be focused onto the sample 118.

Figure 2B shows a detail of area II depicted in figure 2 for another embodiment, in which the particle beam 160 and the beam of light 170 are coaxial and in which the material of the window 154 is shaped as a lens. The material of the window 154 has a central hole, said hole being the aperture 140. The material of the window 152 acts as a lens, thereby focusing the beam of light 170. This has the advantage that the lens is positioned close to the sample, resulting in a better optical performance. The lens of the window 154 can be part of an optical microscope, but can also be part of an illumination system, such as a laser illumination system.

Figure 2C shows a detail of area II depicted in figure 2 for still another embodiment, in which the particle beam and the beam of electromagnetic radiation are coaxial and in which a metal tube surrounds the particle beam. A metal tube 173 is inserted in the central hole of the lens 154, said tube acting as gas constriction. Because the metal tube 173 is electrically conductive, charging of the lens material does not influence the particle beam 160. Because of the elongated form of the tube 173, it constitutes a large gas constriction and thus a low gas leakage is realized.

Figure 2D shows a detail of area II depicted in figure 2, in which the material of the window is formed as an off-axis part of a lens. Because the material of the window 156 is an off-axis part of a lens, beam 170 is deflected away from the particle-optical axis 100. This enables an apparatus in which the mirror 132, shown in figure 2, does not intersect the particle-optical axis, and thus no hole 134 in the mirror is needed to pass the particle beam. For certain applications the mirror 134 may even be eliminated.

Also shown is a second window 196 for the transmission of light produced by a LED (Light Emitting Diode) 198 illuminating the sample 118.

It is remarked that the LED 198 passing light through the second window 196 may not be essential for the illumination of the sample 118: when light is present anywhere in the vacuum chamber 122 (said chamber made of e.g. stainless steel), sufficient light may illuminate the sample 118 by reflections, in which case the second window 196 can be omitted.

It may also be remarked that it may be attractive to use a ring of windows symmetrically distributed around the particle-optical axis 100, even when not all windows are used for illumination. The reason for this is that the part of the enclosure facing the sample may be part of the e.g. magnetic lens of the particle-optical column. The holes in said lens influence the magnetic path of the lens: it introduces a multipole field superimposed on the axial field focusing the particle beam 160. As known to a person skilled in the art of particle-optics the presence of the high-order multipole field caused by such a ring of holes gives a lower disturbance at the axis 100 than an asymmetrically distributed array of holes, the latter being inevitable when one asymmetrically placed window 196 is used.

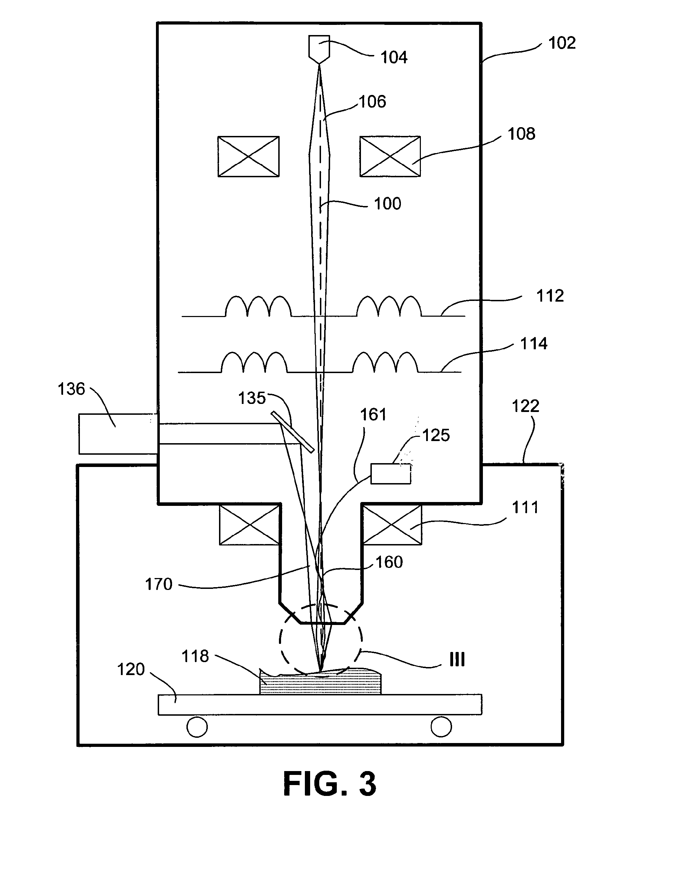

Figure 3 schematically illustrates the apparatus according to the invention, showing a LVSEM with a particle-optical lens of the immersion type.

Figure 3 can be thought of as being derived from figure 2. Figure 3 shows a lens coil 111 generating a magnetic field. The sample end 130 of the enclosure, being made of a material with a high magnetic permeability, is part of (the magnetic path of) the particle-optical lens. The sample 118 is thus immersed in a magnetic field, which focuses the beam 160. For this reason this type of particle-optical lens is named an immersion lens.

It is to be remarked that particle-optical immersion lenses can immerse the sample in a magnetic field, an electrostatic field, or both. Only the magnetic variant is shown here.

Also shown is a secondary electron detector (SED) 125 placed inside the enclosure 102.

As is shown in figure 3A, depicting area III shown in figure 3, the window 156 is shaped as an off-axis part of a lens. A metal tube 173 is inserted in a hole in the window 156, thus forming an aperture 140 to pass the particle beam 160. Secondary electrons 161 emanating from the sample 118 are guided through the aperture 140 into the enclosure 102. To enable this the sample 118 has a small electric bias with respect to the metal tube 173 (bias means not shown). Inside the enclosure 102 these secondary electrons 161 are manipulated (thus: accelerated, focused and/or deflected) and detected by the secondary electron detector 125 (shown in figure 3), as is the case in normal immersion type electron microscopes.
A beam of light 170 coming from the sample 118 is deflected from the particle-optical axis 100 by the off-axis lens156.

The metal tube 173 also acts as a gas constriction with a low gas conductance. The gas leakage from the sample side 130 of the enclosure towards the inside of the enclosure is thus rather limited. This enables the inside of the enclosure to be kept at a pressure of e.g. 10⁻³ mbar, while the sample region is kept at a pressure of e.g. 20 mbar, with pumping means (not shown) as known to one skilled in the art of LVSEM technology.

## Claims

1. A particle-optical apparatus for the irradiation of a sample, comprising
• a source (104) for the production of a particle beam (106, 160),
• an evacuated enclosure (102) enclosing said source (104), and
• an aperture (140) in said enclosure (102),
in which, in operation,
• the particle beam (106, 160) emerges from the enclosure (102) through the aperture (140) and subsequently travels to a sample (118),
• a pressure gradient exists through the aperture (140), and
• electromagnetic radiation emerges from or is sent to the sample (118),
**characterized in that**
• the enclosure includes a window (150) adjacent to the aperture (140),
• said window (150) being transparent to electromagnetic radiation and impenetrable to gas.

2. A particle-optical apparatus according to Claim 1 in which the apparatus is arranged to maintain a pressure gradient over the aperture (140) of at least one order of magnitude.

3. A particle-optical apparatus according to any of the preceding Claims in which the apparatus is arranged to admit gasses to the vicinity of the sample position.

4. A particle-optical apparatus according to any of the preceding Claims in which the window (150) acts as a refractive element.

5. A particle-optical apparatus according to any of the preceding Claims in which the window (150) passes a beam (170) of electro-magnetic radiation, said beam (170) of electro-magnetic radiation and the particle beam (160) being mutually coaxial.

6. A particle-optical apparatus according to any of the preceding Claims in which the electromagnetic radiation is visible light.

7. A particle-optical apparatus according to Claims 1-3 in which the electromagnetic radiation is X-ray radiation.

8. A particle-optical apparatus according to any of the preceding Claims in which the window (150) is located in a pole piece of a particle-optical lens.
